# EUROPEAN PATENT SPECIFICATION

(11) **EP 4 250 898 B1**
(45) Date of publication and mention of the grant of the patent: **01.04.2026**
(21) Application number: 21961714.9
(22) Date of filing: 26.10.2021
(51) Int. Cl.: H10K 71/16, H10K 30/86, H10K 30/40

(54) **PREPARATION METHOD FOR PEROVSKITE CELL HAVING MULTIPLE LAYERS OF HOLE TRANSPORT LAYERS**
HERSTELLUNGSVERFAHREN FÜR PEROWSKITZELLE PEROWSKITZELLE MIT MEHREREN SCHICHTEN VON LOCHTRANSPORTSCHICHTEN
PROCÉDÉ DE PRÉPARATION DE CELLULE DE PÉROVSKITE AYANT DE MULTIPLES COUCHES DE COUCHES DE TRANSPORT DE TROUS

(43) Date of publication of application: 27.09.2023
(73) Proprietor: Contemporary Amperex Technology (Hong Kong) Limited, Central, Central And Western District (HK)
(72) Inventor: WANG, Yandong, Ningde, Fujian 352100 (CN); CHEN, Guodong, Ningde, Fujian 352100 (CN); LIN, Weile, Ningde, Fujian 352100 (CN); LIU, Zhaohui, Ningde, Fujian 352100 (CN); SU, Shuojian, Ningde, Fujian 352100 (CN); GUO, Yongsheng, Ningde, Fujian 352100 (CN)
(74) Representative: Ziebig Hengelhaupt Intellectual Property Attorneys Patentanwaltskanzlei PartGmbB
(86) International application number: PCT/CN2021/126525
(87) International publication number: WO 2023/070338

(56) References cited:
- WO-A1-2016/136729
- CN-A- 109 216 551
- CN-A- 110 484 880
- CN-A- 111 446 367
- CN-A- 111 640 867
- CN-A- 111 640 867
- US-A1- 2008 092 945
- AYDIN ERKAN ET AL: "Room-Temperature-Sputtered Nanocrystalline Nickel Oxide as Hole Transport Layer for p-i-n Perovskite Solar Cells", ACS APPLIED ENERGY MATERIALS, vol. 1, no. 11, 18 October 2018 (2018-10-18), pages 6227 - 6233, XP093144248, ISSN: 2574-0962, DOI: 10.1021/acsaem.8b01263
- AYDIN ERKAN ET AL: "Supporting Information Room-Temperature-Sputtered Nanocrystalline Nickel Oxide as Hole Transport Layer for p-i-n Perovskite Solar Cells", ACS APPLIED ENERGY MATERIALS, vol. 1, no. 11, 26 November 2018 (2018-11-26), XP093144250, ISSN: 2574-0962, DOI: 10.1021/acsaem.8b01263
- SATO H ET AL: "Transparent conducting p-type NiO thin films prepared by magnetron sputtering", THIN SOLID FILMS, ELSEVIER, AMSTERDAM, NL, vol. 236, no. 1-2, 15 December 1993 (1993-12-15), pages 27 - 31, XP025732539, ISSN: 0040-6090, [retrieved on 19931215], DOI: 10.1016/0040-6090(93)90636-4
- ZHANG WEINA ET AL: "Dual interfacial modification engineering with p-type NiO nanocrystals for preparing efficient planar perovskite solar cells", JOURNAL OF MATERIALS CHEMISTRY C, vol. 6, no. 47, 1 January 2018 (2018-01-01), GB, pages 13034 - 13042, XP093144261, ISSN: 2050-7526, DOI: 10.1039/C8TC04475A
- XIAO KE ET AL: "Solution-Processed Monolithic All-Perovskite Triple-Junction Solar Cells with Efficiency Exceeding 20%", ACS ENERGY LETTERS, vol. 5, no. 9, 11 August 2020 (2020-08-11), American Chemical Society, pages 2819 - 2826, XP093144251, ISSN: 2380-8195, DOI: 10.1021/acsenergylett.0c01184
- LIN CHIH MING ET AL: "Effect of the Ni 2+ /Ni 3+ Concentration on the Optoelectronical Properties of Lithium-Doped Nickel Oxide Films", ACS APPLIED ELECTRONIC MATERIALS, vol. 3, no. 3, 21 December 2020 (2020-12-21), pages 1050 - 1057, XP093144252, ISSN: 2637-6113, DOI: 10.1021/acsaelm.0c00752
- CAI LINFENG ET AL: "Toward efficient and stable operation of perovskite solar cells: Impact of sputtered metal oxide interlayers", NANO SELECT, vol. 2, no. 8, 4 February 2021 (2021-02-04), pages 1417 - 1436, XP093144253, ISSN: 2688-4011, DOI: 10.1002/nano.202000290
- WANG KUO CHIN ET AL: "Low-Temperature Sputtered Nickel Oxide Compact Thin Film as Effective Electron Blocking Layer for Mesoscopic NiO/CH3NH3PbI3 Perovskite Heterojunction Solar Cells", APPLIED MATERIALS AND INTERFACES, vol. 6, no. 15, 23 July 2014 (2014-07-23), pages 11851 - 11858, XP093105183, DOI: 10.1021/am503610u

## Description

### TECHNICAL FIELD

This application relates to the technical field of solar cells, and in particular, to a perovskite cell with multiple hole transport layers and a preparation method thereof.

### BACKGROUND

Global climate change has become a growing concern around the world, and people have reached a consensus on gradual reduction of carbon emissions. However, in practice, all countries need to solve conflict between reduction of carbon emissions and economic development, because energy is the lifeblood of the economy. Fossil energy as a major carbon emission source is still dominant in the energy structure. Therefore, it is an urgent task to speed up the development of new energy. New energy includes solar energy, wind energy, nuclear energy, and the like. Among numerous new energy technologies, solar cells have many advantages including zero pollution, zero carbon emission, easy use, wide applicability, and the like.

Perovskite solar cells play an important role in new solar cells, with energy conversion efficiency increased from 3.8% in 2009 to approximately 28% in 2020, and therefore have a quite promising development prospect. The perovskite solar cell typically includes a conductive glass layer, an electron transport layer, a perovskite layer, a hole transport layer, and a back electrode. So far, the hole transport layer of the perovskite solar cell has been mainly made of nickel oxide by using mainstream methods: solution spin-coating and sintering. However, preparation of perovskite solar cells with solution spin-coating not only requires use of toxic solvents, but also has difficulty in controlling uniformity of a formed film with a large area, greatly limiting practical commercial application of the perovskite solar cells. Sintering is not conducive to mass production and produces only a single film layer, which cannot alleviate an interfacial problem. Therefore, there is a need for a new perovskite solar cell that has improved performance, is suitable for mass production, and is also environmentally friendly.

Aydin Erkan ET AL: "Room-Temperature-Sputtered Nanocrystalline Nickel Oxide as Hole Transport Layer for p-i-n Perovskite Solar Cells", ACS APPLIED ENERGY MATERIALS, vol. 1, no. 11, 18 October 2018 (2018-10-18), pages 6227-6233, discloses nickel oxide as a promising hole transport layer for perovskite solar cells.

Wang Kuo Chin ET AL: "Low-Temperature Sputtered Nickel Oxide Compact Thin Film as Effective Electron Blocking Layer for Mesoscopic NiO/CH3NH3PbI3 Perovskite Heterojunction Solar Cells", Applied Materials and Interfaces, vol. 6, no. 15, 23 July 2014 (2014-07-23), pages 11851-11858, discloses low temperature sputtered NiOx thin film and solution-processed NiO_{X} as an effective electron blocking layer for mesoscopic NiO/CH₃NH₃PbI₃ perovskite solar cells.

### SUMMARY

Through extensive and in-depth study, the inventors of this application provide a preparation method of a new perovskite cell, and the method is environmentally friendly and suitable for mass production. The prepared perovskite cell has significantly improved performance.

According to an aspect of this disclosure, a method for preparing a perovskite cell comprising multiple hole transport layers, which are stacked, is provided, including a process of forming the multiple hole transport layers, where the process of forming the multiple hole transport layers includes the following steps:
(1) sputtering a nickel oxide target material in a first atmosphere to form a first hole transport layer, where the first atmosphere contains argon and oxygen, and a volume ratio of the argon to the oxygen is approximately 0:1 to 1.5: 1;
(2) performing annealing treatment on the first hole transport layer, wherein the annealing treatment is performed for 1-45 minutes under a temperature of 200-500°C; and
(3) sputtering the nickel oxide target material onto the first hole transport layer subjected to the annealing treatment in a second atmosphere to form a second hole transport layer, where the second atmosphere contains argon-containing gas and oxygen, a volume ratio of the argon-containing gas to the oxygen is approximately 1:0 to 4:1, and the argon-containing gas contains argon, and optionally hydrogen.

In some embodiments, purity of the nickel oxide is approximately 95wt% or more.

In some embodiments, magnetron sputtering is used in step (1) and/or step (3).

In some embodiments, a thickness of the first hole transport layer and/or the second hole transport layer is approximately 5-50 nm.

In some embodiments, the volume ratio of the argon to the oxygen in the first atmosphere is approximately 0:1 to 1:1.

In some embodiments, in step (2), the annealing treatment is performed under vacuum.

In some embodiments, in step (2), the annealing treatment is performed in a magnetron sputtering device under a temperature of approximately 250-450°C for approximately 5-40 min.

In some embodiments, the volume ratio of the argon-containing gas to the oxygen in the second atmosphere is approximately 1:0 to 5:1.

In some embodiments, the argon-containing gas contains argon and hydrogen, and a volume ratio of the argon to the hydrogen is approximately 90:10 to 99:1.

In some embodiments, the argon-containing gas contains the argon and the hydrogen, and the volume ratio of the argon to the hydrogen is approximately 95:5.

In some embodiments, in step (1) and/or in step (3), a sputtering power is approximately 300 W-10 kW, and an atmospheric pressure is approximately 1×10⁻⁴-100 Pa.

In some embodiments, the method further includes at least one of the following steps: providing a transparent substrate; forming a transparent conductive layer on the transparent substrate; forming the multiple hole transport layers on the transparent conductive layer; forming a perovskite layer on the outermost layer of the multiple hole transport layers; forming an electron transport layer on the perovskite layer; and forming a back electrode on the electron transport layer.

In some embodiments, the method further includes at least one of the following steps: providing a transparent substrate; forming a transparent conductive layer on the transparent substrate; forming an electron transport layer on the transparent conductive layer; forming a perovskite layer on the electron transport layer; forming the multiple hole transport layers on the perovskite layer; and forming a back electrode on the outermost layer of the multiple hole transport layers.

According to another aspect of this disclosure, a perovskite cell prepared by using the above method is provided and includes multiple hole transport layers, and the multiple hole transport layers include at least a first hole transport layer and a second hole transport layer.

In some embodiments, the cell sequentially includes a transparent substrate, a transparent conductive layer, the multiple hole transport layers, a perovskite layer, an electron transport layer, and a back electrode, or sequentially includes a transparent substrate, a transparent conductive layer, an electron transport layer, a perovskite layer, the multiple hole transport layers, and a back electrode.

In some embodiments, the multiple hole transport layers are a double-layer nickel oxide film composed of the first hole transport layer and the second hole transport layer, and the film is about 10-100 nm thick.

In some embodiments, the transparent conductive layer is selected from one or more of indium tin oxide (ITO) and fluorine-doped tin dioxide (FTO).

In some embodiments, the electron transport layer is selected from one or more of [6, 6]-phenyl-C61-butyric acid methyl ester (PCBM), C60, BCP (2,9-dimethyl-4,7-diphenyl-1,10-phenanthroline), and SnO₂.

In some embodiments, the back electrode is selected from one or more of indium tin oxide (ITO), tungsten-doped indium oxide (IWO), aluminium-doped zinc oxide (AZO), Au, Ag, Cu, Al, Ni, Cr, Bi, Pt, and Mg.

In some embodiments, the transparent substrate is made of glass.

In some embodiments, the perovskite layer contains one or more of CH₃NH₃PbI₃, CH₃NH₃PbI₃₋ₓClₓ, and CH₃NH₃PbI₃₋ₓBrₓ, and 0<x<3.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings described below in the embodiments of this application are merely exemplary, and a person of ordinary skill in the art may still derive other drawings from these accompanying drawings without creative efforts.
FIG. 1 is a schematic structural diagram of a perovskite cell with multiple hole transport layers according to an embodiment of this application.
FIG. 2 is a schematic structural diagram of a perovskite cell with multiple hole transport layers according to another embodiment of this application.

In the accompanying drawings, the parts are not drawn to scale.

Reference signs are described as follows:
100: perovskite cell;
102: transparent substrate;
104: transparent conductive layer;
106: first hole transport layer;
108: second hole transport layer;
110: perovskite layer;
120: electron transport layer; and
140: back electrode.

### DESCRIPTION OF EMBODIMENTS

The following further describes the embodiments of this application in detail with reference to the accompanying drawings and implementations. The detailed description and accompanying drawings of the following embodiments are used to exemplarily illustrate the principle of this application, but are not intended to limit the scope of this application, that is, this application is not limited to the described embodiments.

Ranges disclosed herein are defined in the form of lower and upper limits. Given ranges are defined by selecting lower and upper limits, and the selected lower and upper limits define boundaries of special ranges. Ranges defined in the method may or may not include end values, and any combinations may be used, meaning any lower limit may be combined with any upper limit to form a range. For example, if ranges of 60-120 and 80-110 are provided for a specific parameter, it is understood that ranges of 60-110 and 80-120 can also be envisioned. In addition, if lower limit values of a range are given as 1 and 2, and upper limit values of the range are given as 3, 4, and 5, the following ranges can all be envisioned: 1-3, 1-4, 1-5, 2-3, 2-4, and 2-5. In this application, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is just a short representation of a combination of these values. In addition, when a parameter is expressed as an integer greater than or equal to 2, this is equivalent to disclosure that the parameter is, for example, an integer among 2, 3, 4, 5, 6, 7, 8, 9, 10, 11, 12, and so on.

In this application, unless otherwise specified, all the embodiments and optional embodiments mentioned herein may be combined with each other to form new technical solutions.

In this application, unless otherwise specified, all the technical features and optional features mentioned herein may be combined with each other to form new technical solutions.

In this application, unless otherwise specified, all the steps mentioned herein may be performed sequentially or randomly, and are preferably performed sequentially. For example, a method including steps (a) and (b) indicates that the method may include steps (a) and (b) performed in sequence, or may include steps (b) and (a) performed in sequence. For example, that the method may further include step (c) indicates that step (c) may be added to the method in any order. For example, the method may include steps (a), (b), and (c), or steps (a), (c), and (b), or steps (c), (a), and (b), or the like.

In this application, unless otherwise specified, "include" and "contain" mentioned herein may refer to open or closed inclusion. For example, terms "include" and "contain" can mean that other unlisted components may also be included or contained, or only listed components may be included or contained.

In the descriptions of this specification, it should be noted that "more than" or "less than" is inclusive of the present number and that "more" in "one or more" means two or more than two, unless otherwise specified. In the descriptions of this specification, the terms "first", "second", "third", and the like are merely intended for a purpose of description, and shall not be understood as an indication or implication of relative importance.

In the descriptions of this specification, unless otherwise stated, the term "or" is inclusive. For example, the phrase "A or B" means "A, B, or both A and B". More specifically, any one of the following conditions satisfies the condition "A or B": A is true (or present) and B is false (or not present); A is false (or not present) and B is true (or present); or both A and B are true (or present).

### Preparation method of perovskite cell with multiple hole transport layers

A perovskite cell in the prior art typically includes a transparent substrate, a transparent conductive layer, a hole transport layer, a perovskite layer, an electron transport layer, and a back electrode.

The claimed invention provides a method for preparing a perovskite cell with multiple hole transport layers, and the method includes a process of forming the multiple hole transport layers, where the process of forming the multiple hole transport layers includes the following steps:
(1) sputtering a nickel oxide target material in a first atmosphere to form a first hole transport layer, where the first atmosphere contains argon and oxygen, and a volume ratio of the argon to the oxygen is approximately 0:1 to 1.5: 1;
(2) performing annealing treatment on the first hole transport layer, wherein the annealing treatment is performed for 1-45 minutes under a temperature of 200-500°C; and
(3) sputtering the nickel oxide target material onto the first hole transport layer subjected to the annealing treatment in a second atmosphere to form a second hole transport layer, where the second atmosphere contains argon-containing gas and oxygen, a volume ratio of the argon-containing gas to the oxygen is approximately 1:0 to 4:1, and the argon-containing gas contains argon, and optionally hydrogen.

In some embodiments, magnetron sputtering is used in step (1). In some embodiments, magnetron sputtering is used in step (3). In some embodiments, the magnetron sputtering is used in step (1) and step (3).

The nickel oxide target material used in the method of this disclosure may contain nickel oxide with purity of approximately 95wt% or more. For example, the purity of the nickel oxide may be approximately 95wt% or more, approximately 96wt% or more, approximately 97wt% or more, approximately 98wt% or more, and even approximately 99wt% or more.

In the method of this disclosure, sputtering such as magnetron sputtering is performed in a suitable atmosphere. Sputtering in step (1) of forming the first hole transport layer is performed in the first atmosphere. The first atmosphere contains the argon and the oxygen. In the first atmosphere, the volume ratio of the argon to the oxygen is approximately 0:1 to 1.5:1, and includes but is not limited to approximately 0:1, approximately 0.1:1, approximately 0.2:1, approximately 0.3:1, approximately 0.4:1, approximately 0.5:1, approximately 0.6:1, approximately 0.7:1, approximately 0.8:1, approximately 0.9:1, approximately 1.0:1, approximately 1.1:1, approximately 1.2:1, approximately 1.3:1, approximately 1.4:1, approximately 1.5:1, and a range formed by any two of the above volume ratios as endpoints. In some embodiments, the volume ratio of the argon to the oxygen in the first atmosphere is approximately 0:1 to 1:1, and includes but is not limited to approximately 0:1, approximately 0.1:1, approximately 0.2:1, approximately 0.3:1, approximately 0.4:1, approximately 0.5:1, approximately 0.6:1, approximately 0.7:1, approximately 0.8:1, approximately 0.9:1, approximately 1.0:1, and a range formed by any two of the above volume ratios as endpoints. In some embodiments, the volume ratio of the argon to the oxygen in the first atmosphere is approximately 0:1. In this case, the first atmosphere does not contain the argon. In some embodiments, the first atmosphere consists of the oxygen. In some embodiments, the volume ratio of the argon to the oxygen in the first atmosphere is approximately 0.2:1. In some embodiments, the volume ratio of the argon to the oxygen in the first atmosphere is approximately 1:1. In some embodiments, the first atmosphere consists of the argon and the oxygen.

Sputtering in step (3) of forming the second hole transport layer is performed in the second atmosphere. The second atmosphere contains the argon-containing gas and the oxygen. As a person skilled in the art can understand that the argon-containing gas described herein does not contain oxygen. In some embodiments, the volume ratio of the argon-containing gas to the oxygen is approximately 1:0 to 4:1, and includes but is not limited to approximately 1:0, approximately 100:1, approximately 90:1, approximately 80:1, approximately 70:1, approximately 60:1, approximately 50:1, approximately 40:1, approximately 30:1, approximately 20:1, approximately 10:1, approximately 9:1, approximately 8:1, approximately 7:1, approximately 6:1, approximately 5:1, approximately 4:1, and a range formed by any two of the above volume ratios as endpoints. In some embodiments, the volume ratio of the argon-containing gas to the oxygen is approximately 1:0 to 5:1, and includes but is not limited to approximately 1:0, approximately 100:1, approximately 90:1, approximately 80:1, approximately 70:1, approximately 60:1, approximately 50:1, approximately 40:1, approximately 30:1, approximately 20:1, approximately 10:1, approximately 9:1, approximately 8:1, approximately 7:1, approximately 6:1, approximately 5:1, and a range formed by any two of the above volume ratios as endpoints. In some embodiments, the volume ratio of the argon-containing gas to the oxygen in the second atmosphere is approximately 1:0. In this case, the second atmosphere does not contain the oxygen. In some embodiments, the second atmosphere consists of the argon-containing gas. In some embodiments, a volume ratio of argon-containing gas to oxygen in the second atmosphere is approximately 5:1. In some embodiments, the second atmosphere consists of the argon-containing gas and the oxygen. In this specification, the argon-containing gas contains argon, and optionally hydrogen. In some embodiments, the argon-containing gas consists of the argon. In some embodiments, the argon-containing gas contains the argon and the hydrogen. In some embodiments, a volume ratio of the argon to the hydrogen is approximately 90:10 to 99:1, and includes but is not limited to approximately 90:10, approximately 91:9, approximately 92:8, approximately 93:7, approximately 94:6, approximately 95:5, approximately 96:4, approximately 97:3, approximately 98:2, approximately 99:1, and a range formed by any two of the above volume ratios as endpoints. In some embodiments, the volume ratio of the argon to the hydrogen is approximately 95:5. In some embodiments, the argon-containing gas consists of the argon and the hydrogen.

Without wishing to be bound by any special theory, it is believed that due to a difference between the first atmosphere and the second atmosphere, nickel ions in the first hole transport layer are present mainly in a trivalent state, and nickel ions in the second hole transport layer are present mainly in a divalent state. The "mainly" mentioned herein means approximately 50 mol% or more, for example, approximately 55 mol% or more, approximately 60 mol% or more, approximately 70 mol% or more, approximately 80 mol% or more, approximately 90 mol% or more, approximately 95 mol% or more, approximately 98 mol% or more, or approximately 100 mol%.

A sputtering power in step (1) of forming the first hole transport layer is approximately 300 W-10 kW, and includes but is not limited to approximately 400 W, approximately 500 W, approximately 600 W, approximately 700 W, approximately 800 W, approximately 900 W, approximately 1 kW, approximately 2 kW, approximately 3 kW, approximately 4 kW, approximately 5 kW, approximately 6 kW, approximately 7 kW, approximately 8 kW, approximately 9 kW, approximately 10 kW, and a range formed by any two of the above power values as endpoints. The sputtering power in step (1) may be adjusted as required. For example, in some embodiments, the sputtering power in step (1) is approximately 1 kW.

A sputtering pressure in step (1) of forming the first hole transport layer is approximately 1×10⁻⁴-100 Pa. In some embodiments, the sputtering pressure includes but is not limited to approximately 1×10⁻³-90 Pa, approximately 1×10⁻²-80 Pa, approximately 0.1-70 Pa, approximately 1-60 Pa, approximately 2-50 Pa, approximately 3-40 Pa, approximately 4-50 Pa, approximately 5-40 Pa, approximately 6-30 Pa, approximately 7-20 Pa, and approximately 8-10 Pa. For example, in some embodiments, the sputtering pressure includes but is not limited to approximately 0.001 Pa, approximately 0.005 Pa, approximately 0.01 Pa, approximately 0.015 Pa, approximately 0.020 Pa, approximately 0.025 Pa, approximately 0.030 Pa, approximately 0.035 Pa, and a range formed by any two of the above pressure values as endpoints. In some embodiments, the sputtering pressure is approximately 0.020 Pa.

A sputtering power in step (3) of forming the second hole transport layer is approximately 300 W-10 kW, and includes but is not limited to approximately 400 W, approximately 500 W, approximately 600 W, approximately 700 W, approximately 800 W, approximately 900 W, approximately 1 kW, approximately 2 kW, approximately 3 kW, approximately 4 kW, approximately 5 kW, approximately 6 kW, approximately 7 kW, approximately 8 kW, approximately 9 kW, approximately 10 kW, and a range formed by any two of the above power values as endpoints. The sputtering power in step (3) may be adjusted as required. For example, in some embodiments, the sputtering power in step (3) is approximately 1 kW. The sputtering powers in step (1) and step (3) may be the same or different.

A sputtering pressure in step (3) of forming the second hole transport layer is approximately 1×10⁻⁴-100 Pa. In some embodiments, the sputtering pressure includes but is not limited to approximately 1×10⁻³-90 Pa, approximately 1×10⁻²-80 Pa, approximately 0.1-70 Pa, approximately 1-60 Pa, approximately 2-50 Pa, approximately 3-40 Pa, approximately 4-50 Pa, approximately 5-40 Pa, approximately 6-30 Pa, approximately 7-20 Pa, and approximately 8-10 Pa. For example, in some embodiments, the sputtering pressure includes but is not limited to approximately 0.001 Pa, approximately 0.005 Pa, approximately 0.01 Pa, approximately 0.015 Pa, approximately 0.020 Pa, approximately 0.025 Pa, approximately 0.030 Pa, approximately 0.035 Pa, and a range formed by any two of the above pressure values as endpoints. In some embodiments, the sputtering pressure is approximately 0.020 Pa. The sputtering pressures in step (1) and step (3) may be the same or different.

Sputtering times in step (1) and step (3) are not particularly limited, and may be selected and adjusted based on a thickness of the first hole transport layer and a thickness of the second hole transport layer, respectively. For example, in some embodiments, the sputtering time in step (1) includes but is not limited to approximately 0.5-10 minutes, approximately 1-9 minutes, approximately 1.5-8 minutes, approximately 2-7 minutes, approximately 2.5-6 minutes, and approximately 3-5 minutes. In some embodiments, the sputtering time in step (3) includes but is not limited to approximately 0.5-10 minutes, approximately 1-9 minutes, approximately 1.5-8 minutes, approximately 2-7 minutes, approximately 2.5-6 minutes, and approximately 3-5 minutes. The sputtering times in step (1) and step (3) may be the same or different.

The thickness of the first hole transport layer is not particularly limited. For example, the thickness may be approximately 5-50 nm and includes but is not limited to approximately 6 nm, approximately 7 nm, approximately 8 nm, approximately 9 nm, approximately 10 nm, approximately 11 nm, approximately 12 nm, approximately 13 nm, approximately 14 nm, approximately 15 nm, approximately 16 nm, approximately 17 nm, approximately 18 nm, approximately 19 nm, approximately 20 nm, approximately 21 nm, approximately 22 nm, approximately 23 nm, approximately 24 nm, approximately 25 nm, approximately 26 nm, approximately 27 nm, approximately 28 nm, approximately 29 nm, approximately 30 nm, approximately 31 nm, approximately 32 nm, approximately 33 nm, approximately 34 nm, approximately 35 nm, approximately 36 nm, approximately 37 nm, approximately 38 nm, approximately 39 nm, approximately 40 nm, approximately 41 nm, approximately 42 nm, approximately 43 nm, approximately 44 nm, approximately 45 nm, approximately 46 nm, approximately 47 nm, approximately 48 nm, approximately 49 nm, approximately 50 nm, and a range formed by any two of the above thickness values as endpoints.

The thickness of the second hole transport layer is not particularly limited. For example, the thickness may be approximately 5-50 nm and includes but is not limited to approximately 6 nm, approximately 7 nm, approximately 8 nm, approximately 9 nm, approximately 10 nm, approximately 11 nm, approximately 12 nm, approximately 13 nm, approximately 14 nm, approximately 15 nm, approximately 16 nm, approximately 17 nm, approximately 18 nm, approximately 19 nm, approximately 20 nm, approximately 21 nm, approximately 22 nm, approximately 23 nm, approximately 24 nm, approximately 25 nm, approximately 26 nm, approximately 27 nm, approximately 28 nm, approximately 29 nm, approximately 30 nm, approximately 31 nm, approximately 32 nm, approximately 33 nm, approximately 34 nm, approximately 35 nm, approximately 36 nm, approximately 37 nm, approximately 38 nm, approximately 39 nm, approximately 40 nm, approximately 41 nm, approximately 42 nm, approximately 43 nm, approximately 44 nm, approximately 45 nm, approximately 46 nm, approximately 47 nm, approximately 48 nm, approximately 49 nm, approximately 50 nm, and a range formed by any two of the above thickness values as endpoints.

A total thickness of the first hole transport layer and second hole transport layer may be approximately within a range of 10-100 nm. For example, the total thickness of the first hole transport layer and second hole transport layer may be approximately 10-100 nm, approximately 15-95 nm, approximately 20-90 nm, approximately 25-85 nm, approximately 30-80 nm, approximately 35-75 nm, approximately 40-70 nm, approximately 45-65 nm, or approximately 50-60 nm.

In step (2), the annealing treatment may be performed under a temperature of 200-500°C. In some embodiments, the annealing treatment temperature includes but is not limited to approximately 200°C, approximately 210°C, approximately 220°C, approximately 230°C, approximately 240°C, approximately 250°C, approximately 260°C, approximately 270°C, approximately 280°C, approximately 290°C, approximately 300°C, approximately 310°C, approximately 320°C, approximately 330°C, approximately 340°C, approximately 350°C, approximately 360°C, approximately 370°C, approximately 380°C, approximately 390°C, approximately 400°C, approximately 410°C, approximately 420°C, approximately 430°C, approximately 440°C, approximately 450°C, approximately 460°C, approximately 470°C, approximately 480°C, approximately 490°C, approximately 500°C, and a range formed by any two of the above temperature values as endpoints. In some embodiments, the annealing treatment temperature is approximately 250-450°C, for example, approximately 300-400°C.

In step (2), an annealing treatment time may be approximately 1-45 min, and includes but is not limited to approximately 1 min, approximately 5 min, approximately 10 min, approximately 15 min, approximately 20 min, approximately 25 min, approximately 30 min, approximately 35 min, approximately 40 min, approximately 45 min, and a range formed by any two of the above time values as endpoints. In the claimed invention, the annealing treatment is performed for 1-45 minutes under a temperature of 200-500°C.

In some embodiments, the annealing treatment is performed under vacuum in step (2).

In some embodiments, the annealing treatment is performed in a sputtering device, for example, a magnetron sputtering device in step (2).

After the step (3) of forming the second hole transport layer is performed, annealing may be performed according to step (2) or may not be performed.

A double-layer hole transport layer including the first hole transport layer and the second hole transport layer is formed in step (1) to step (3).

It is not difficult to understand that if necessary, the sputtering and annealing steps may be repeated according to the above method, so as to form three, four, or even more hole transport layers. All these variants fall within the scope of this application.

In some embodiments, the method further includes a step of providing a transparent substrate. In some embodiments, the transparent substrate is made of glass.

In some embodiments, the method further includes a step of forming a transparent conductive layer on the transparent substrate. The transparent conductive layer is selected from one or more of indium tin oxide (ITO) and fluorine-doped tin dioxide (FTO). The step of forming the transparent conductive layer on the transparent substrate may be performed according to any technology known in the art for forming transparent conductive layer and any technology developed in the future for forming transparent conductive layer.

In some embodiments, the method further includes a step of forming a perovskite layer. The perovskite layer may be made of any perovskite material known in the art suitable for preparing perovskite solar cell and any perovskite material developed in the future suitable for preparing perovskite solar cell. For example, the perovskite layer contains one or more of CH₃NH₃PbI₃, CH₃NH₃PbI₃₋ₓClₓ, and CH₃NH₃PbI₃₋ₓBrₓ, and 0<x<3. The step of forming the perovskite layer may be performed according to any technology known in the art for forming perovskite layer and any technology developed in the future for forming perovskite layer.

In some embodiments, the method further includes a step of forming an electron transport layer. The electron transport layer may be made of any material known in the art suitable for making electron transport layer and any material developed in the future suitable for making electron transport layer. For example, the electron transport layer may be made of one or more of [6, 6]-phenyl-C61-butyric acid methyl ester (PCBM), C60, BCP (2,9-dimethyl-4,7-diphenyl-1,10-phenanthroline), and SnO₂. The step of forming the electron transport layer may be performed according to any technology known in the art for forming electron transport layer and any technology developed in the future for forming electron transport layer.

In some embodiments, the method further includes a step of providing a back electrode. The back electrode may be made of any material known in the art suitable for making back electrode and any material developed in the future suitable for making back electrode. For example, the back electrode may be made of one or more of ITO, IWO, AZO, Au, Ag, Cu, Al, Ni, Cr, Bi, Pt, and Mg. The step of providing the back electrode may be performed according to any technology known in the art for providing back electrode and any technology developed in the future for providing back electrode.

In some embodiments, the multiple hole transport layers of this application may be formed on the transparent conductive layer. For example, the first hole transport layer may be formed on the transparent conductive layer, and the second hole transport layer is formed on the first hole transport layer. Certainly, more hole transport layers may be formed in such a way. In this case, the perovskite layer may be formed on the multiple hole transport layers, the electron transport layer may be formed on the perovskite layer, and the back electrode may be provided on the electron transport layer.

In some embodiments, the electron transport layer may be formed on the transparent conductive layer. In this case, the perovskite layer may be formed on the electron transport layer. The multiple hole transport layers of this application may be formed on the perovskite layer. For example, the first hole transport layer may be formed on the perovskite layer, and the second hole transport layer is formed on the first hole transport layer. Certainly, more hole transport layers may be formed in such a way. The back electrode may be provided on the multiple hole transport layers of this application.

It should be pointed out that "...formed on ..." herein is merely for description and is not intended to constitute any limitation. For example, the following embodiments also fall within the protection scope of this application: forming multiple hole transport layers or an electron transport layer on a back electrode; forming a perovskite layer on the multiple hole transport layers or the electron transport layer; forming the electron transport layer or the multiple hole transport layers on the perovskite layer; forming a transparent conductive layer on the electron transport layer or the multiple hole transport layers; and providing a transparent substrate on the transparent conductive layer.

### Perovskite cell with multiple hole transport layers

With the method described above, a new perovskite cell is provided in this disclosure and includes multiple hole transport layers, and the multiple hole transport layers include at least a first hole transport layer and a second hole transport layer.

A thickness of the first hole transport layer is not particularly limited. For example, the thickness may be approximately 5-50 nm and includes but is not limited to approximately 6 nm, approximately 7 nm, approximately 8 nm, approximately 9 nm, approximately 10 nm, approximately 11 nm, approximately 12 nm, approximately 13 nm, approximately 14 nm, approximately 15 nm, approximately 16 nm, approximately 17 nm, approximately 18 nm, approximately 19 nm, approximately 20 nm, approximately 21 nm, approximately 22 nm, approximately 23 nm, approximately 24 nm, approximately 25 nm, approximately 26 nm, approximately 27 nm, approximately 28 nm, approximately 29 nm, approximately 30 nm, approximately 31 nm, approximately 32 nm, approximately 33 nm, approximately 34 nm, approximately 35 nm, approximately 36 nm, approximately 37 nm, approximately 38 nm, approximately 39 nm, approximately 40 nm, approximately 41 nm, approximately 42 nm, approximately 43 nm, approximately 44 nm, approximately 45 nm, approximately 46 nm, approximately 47 nm, approximately 48 nm, approximately 49 nm, approximately 50 nm, and a range formed by any two of the above thickness values as endpoints.

A thickness of the second hole transport layer is not particularly limited. For example, the thickness may be approximately 5-50 nm and includes but is not limited to approximately 6 nm, approximately 7 nm, approximately 8 nm, approximately 9 nm, approximately 10 nm, approximately 11 nm, approximately 12 nm, approximately 13 nm, approximately 14 nm, approximately 15 nm, approximately 16 nm, approximately 17 nm, approximately 18 nm, approximately 19 nm, approximately 20 nm, approximately 21 nm, approximately 22 nm, approximately 23 nm, approximately 24 nm, approximately 25 nm, approximately 26 nm, approximately 27 nm, approximately 28 nm, approximately 29 nm, approximately 30 nm, approximately 31 nm, approximately 32 nm, approximately 33 nm, approximately 34 nm, approximately 35 nm, approximately 36 nm, approximately 37 nm, approximately 38 nm, approximately 39 nm, approximately 40 nm, approximately 41 nm, approximately 42 nm, approximately 43 nm, approximately 44 nm, approximately 45 nm, approximately 46 nm, approximately 47 nm, approximately 48 nm, approximately 49 nm, approximately 50 nm, and a range formed by any two of the above thickness values as endpoints.

Nickel ions in the first hole transport layer are present mainly in a trivalent state, and nickel ions in the second hole transport layer are present mainly in a divalent state. The "mainly" mentioned herein means approximately 50 mol% or more, for example, approximately 55 mol% or more, approximately 60 mol% or more, approximately 70 mol% or more, approximately 80 mol% or more, approximately 90 mol% or more, approximately 95 mol% or more, approximately 98 mol% or more, or approximately 100 mol%.

It can be understood that the multiple hole transport layers described herein may alternatively include three or more hole transport layers, and a thickness of each layer may also fall within the above thickness range of the first hole transport layer and/or the second hole transport layer.

In some embodiments, the multiple hole transport layers are a double-layer nickel oxide film composed of the first hole transport layer and the second hole transport layer. A total thickness of the first hole transport layer and second hole transport layer may be approximately within 10-100 nm. For example, the total thickness of the first hole transport layer and second hole transport layer may be approximately 10-100 nm, approximately 15-95 nm, approximately 20-90 nm, approximately 25-85 nm, approximately 30-80 nm, approximately 35-75 nm, approximately 40-70 nm, approximately 45-65 nm, or approximately 50-60 nm.

In some embodiments, the cell sequentially includes a transparent substrate, a transparent conductive layer, the multiple hole transport layers, a perovskite layer, an electron transport layer, and a back electrode. In some embodiments, the cell sequentially includes a transparent substrate, a transparent conductive layer, an electron transport layer, a perovskite layer, the multiple hole transport layers, and a back electrode.

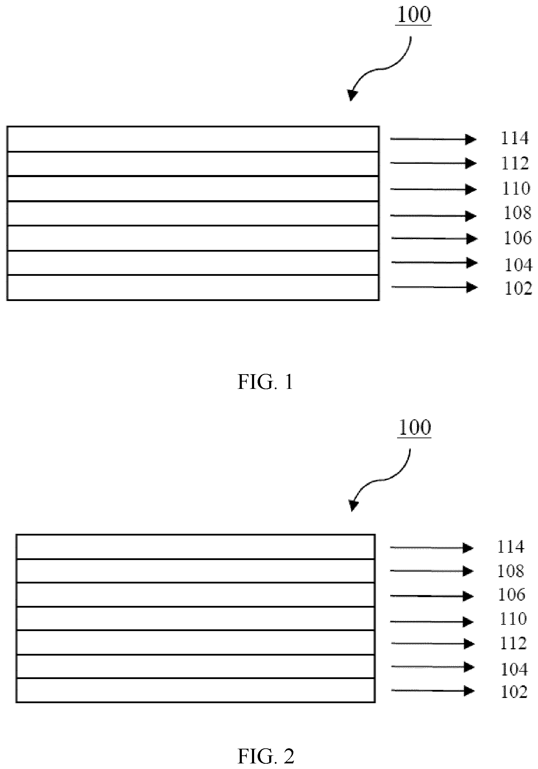

For example, as shown in FIG. 1, a perovskite cell 100 containing multiple hole transport layers includes a transparent substrate 102, a transparent conductive layer 104, a first hole transport layer 106, a second hole transport layer 108, a perovskite layer 110, an electron transport layer 112, and a back electrode 114. As shown in FIG. 2, another perovskite cell 100 containing multiple hole transport layers includes a transparent substrate 102, a transparent conductive layer 104, an electron transport layer 112, a perovskite layer 110, a first hole transport layer 106, a second hole transport layer 108, and a back electrode 114.

The transparent conductive layer may be made of any material known in the prior art for making transparent conductive layer and any material developed in the future for making transparent conductive layer. For example, the transparent conductive layer is selected from one or more of indium tin oxide (ITO) and fluorine-doped tin dioxide (FTO).

The electron transport layer may be made of any material known in the prior art for making electron transport layer and any material developed in the future for making electron transport layer. For example, the electron transport layer is selected from one or more of [6, 6]-phenyl-C61-butyric acid methyl ester (PCBM), C60, BCP (2,9-dimethyl-4,7-diphenyl-1,10-phenanthroline), and SnO₂.

The back electrode may be made of any material known in the prior art for making back electrode and any material developed in the future for making back electrode. For example, the back electrode may be selected from one or more of ITO, IWO, AZO, Au, Ag, Cu, Al, Ni, Cr, Bi, Pt, and Mg.

The transparent substrate may be made of any material known in the prior art for making transparent substrate and any material developed in the future for making transparent substrate. For example, the transparent substrate is made of glass.

The perovskite layer may be made of any material known in the prior art for making perovskite layer and any material developed in the future for making perovskite layer. For example, the perovskite layer contains one or more of CH₃NH₃PbI₃, CH₃NH₃PbI₃₋ₓClₓ, and CH₃NH₃PbI₃₋ₓBrₓ, and 0<x<3.

### Technical effect

In the prior art, a hole transport layer in a perovskite cell is usually prepared by using solution spin-coating and sintering. Solution spin-coating requires use of toxic solvents and produces only a single film layer, and is very difficult to control uniformity of a formed film with a large area. Therefore, it is not conductive to mass production, greatly limiting practical application of perovskite solar cells in industry. In this disclosure, a nickel oxide film layer is prepared by sputtering, so that different functional layers can be continuously prepared in a same device and a same material can implement different functions in different processes, thereby helping implement continuous mass production and more easily obtaining a high-quality perovskite solar cell. In addition, energy consumption is reduced by reducing annealing operations.

The method in this disclosure is easy to prepare a high-quality hole transport layer film, obviously reduces surface defects of the nickel oxide hole transport layer and obviously improves electrical performance of the nickel oxide hole transport layer, thereby increasing conversion efficiency of perovskite cells. In addition, film coating uniformity and process controllability are obviously improved, thereby increasing stability of the perovskite cells.

### Examples

The following will further detail this application with reference to the examples. It should be understood that these examples enumerated are only intended for illustration other than limiting the scope of this application.

### Conductivity test method:

Conductivity of a film layer was measured by using an HMS-3000 Hall measurement system by ECOPIA. A nickel oxide film layer was directly sputtered onto a glass substrate, and then a 1 cm×1 cm sample was taken for Hall test with the following parameters: current: 1nA, and thickness: 20 nm.

### Transmittance test method:

Transmittance of a nickel oxide film layer was measured by using a UV-3600i Plus spectrophotometer by Shimadzu. The nickel oxide film layer was directly sputtered onto a glass substrate, and then a 5 cm×5 cm sample was taken for measuring transmittance within a wavelength of 300-1100 nm.

### Test method of component efficiency:

According to standard IEC61215: 2016 efficiency test methods, component efficiency was tested by using IVS-KA6000 by Enlitech Technology Co., Ltd.

### Example 1

(1) An 1.5 cm×1.5 cm FTO conductive glass sheet was taken; 2/3 of the FTO conductive glass sheet was covered with an M3 waterproof adhesive tape; 1/3 of the FTO conductive glass sheet was etched with Zn powder and 1 mol/L hydrochloric acid; and the FTO conductive glass sheet etched was sequentially cleaned with acetone and isopropanol for several times and finally immersed into deionized water for ultrasonic treatment for 10 min.
(2) The FTO conductive glass sheet treated was dried in a blast drying oven, followed by sputtering nickel oxide in a magnetron sputtering device, to form a first hole transport layer on the FTO conductive glass sheet. A radio-frequency power supply was used in sputtering, where a power was 1 kW, a chamber pressure was 0.02 Pa, a flow rate of argon was 200 sccm (standard cubic centimeter per minute), and a flow rate of oxygen was 200 sccm, with a volume ratio of the argon to the oxygen being 1:1. A film coating time was 5 min and a film layer was 30 nm thick. Then, annealing was performed in the magnetron sputtering device under a temperature of 350°C for 30 min.
(3) Nickel oxide was sputtered again onto the annealed FTO glass sheet coated with the nickel oxide film layer in the magnetron sputtering device, thereby forming a second hole transport layer on the first hole transport layer. A radio-frequency power supply was used in sputtering, where a power was 1 kW, a chamber pressure was 0.02 Pa, a flow rate of argon-containing gas was 200 sccm, and a flow rate of oxygen was 50 sccm, with a volume ratio of the argon-containing gas to the oxygen being 4:1. The argon-containing gas was a mixture of argon and hydrogen, where a volume ratio of the argon to the hydrogen was 95:5. A film coating time was 1 min and a film layer was 5 nm thick.
(4) A perovskite layer was formed on the second hole transport layer through spin-coating at a speed of 3000-4500 rpm, and the glass sheet was heated under a temperature of 110°C for 30 min on a glove box heating plate, and then annealed to room temperature. An active substance of the perovskite layer was CH₃NH₃PbI₃.
(5) After formation of the perovskite layer, the sample was placed in a vacuum coating machine; C60 powder and BCP powder were separately placed in a quartz crucible; C60 powder was first evaporated at 0.05 Å/s to form a 5 nm thick film, and then evaporated at 0.1 Å/s to form a 30 nm thick film. Then, BCP was evaporated at 0.05 Å/s to form a 2 nm thick film, and then evaporated at 0.1 Å/s to form an 8 nm thick film, thereby forming an electron transport layer on the perovskite layer.
(6) The sample was placed into an evaporator, and a layer of Ag electrode was evaporated onto the electron transport layer to obtain a perovskite solar cell.

### Example 2

It was similar to Example 1 except that the flow rate of the argon in step (2) was changed to 0 sccm, and the flow rate of the oxygen remained at 200 sccm, with the volume ratio of the argon to the oxygen being 0:1.

### Example 3

It was similar to Example 1 except that the flow rate of the argon in step (2) was changed to 50 sccm, and the flow rate of oxygen remained at 200 sccm, with the volume ratio of the argon to the oxygen being 1:4.

### Example 4

It was similar to Example 1 except that an annealing temperature in step (2) was changed to 250°C.

### Example 5

It was similar to Example 1 except that an annealing temperature in step (2) was changed to 450°C.

### Example 6

It was similar to Example 1 except that an annealing time in step ② was changed to 5 min.

### Example 7

It was similar to Example 1 except that an annealing time in step ② was changed to 40 min.

### Example 8

It was similar to Example 1 except that a flow rate of oxygen in step ③ was changed to 0 sccm, and a flow rate of argon-containing gas remained at 200 sccm, with a volume ratio of the argon-containing gas to the oxygen being 1:0.

### Example 9

It was similar to Example 1 except that a flow rate of oxygen in step (3) was changed to 40 sccm, and a flow rate of argon-containing gas remained at 200 sccm, with a volume ratio of the argon-containing gas to the oxygen being 5:1.

### Example 10

It was similar to Example 1 except that argon-containing gas in step (3) was changed to pure argon, a flow rate of the argon-containing gas was 200 sccm, and a flow rate of oxygen was changed to 40 sccm, with a volume ratio of the argon to the oxygen being 5:1.

### Comparative Example 1

It was similar to Example 1 except that step (2) was omitted.

### Comparative Example 2

It was similar to Example 1 except that step (3) was omitted.

### Comparative Example 3

It was similar to Example 1 except that an annealing treatment in step (2) was omitted.

### Comparative Example 4

(1) A 1.5 cm×1.5 cm FTO conductive glass sheet was taken; 2/3 of the FTO conductive glass sheet was covered with an M3 waterproof adhesive tape; 1/3 of the FTO conductive glass sheetswas etched with Zn powder and 1 mol/L hydrochloric acid; and the FTO conductive glass sheet etched was sequentially cleaned with acetone and isopropanol for several times and finally immersed into deionized water for ultrasonic treatment for 10 min.
(2) 48.3 mg of nickel nitrate hexahydrate was taken by using an electronic balance, and then 1 mL of methanol was added into a glove box. After magnetic stirring for 2 h, a light green clear liquid was obtained and then filtrated to obtain a precursor liquid of a NiOx layer for later use. Before solution spin-coating, the FTO conductive glass sheet was treated for 10 min with ultraviolet rays for later use (with a maximum interval of 15 min). A spin-coating speed was set to 6 krpm, a spin-coating acceleration was set to 1 krpm, and a spin-coating time was set to 30s. The FTO conductive glass sheet was placed on a spin coater sample table and 80 µL of NiOx layer precursor liquid was dropped onto the FTO conductive glass sheet. After spin-coating, the FTO conductive glass sheet was subjected to annealing process: heated to 80°C and remained at this temperature for 10 min, and then heated up to 345°C within 30 min and remained at 345°C for 30 min. The FTO conductive glass sheet was placed into a sample box after being cooled to 100°C.
(3) A perovskite layer was formed through spin-coating on the hole transport layer formed in step (2) at a speed of 3000-4500 rpm, and the glass sheet was heated under a temperature of 110°C for 30 min on a glove box heating plate, and then annealed to room temperature. An active substance of the perovskite layer was CH₃NH₃PbI₃.
(4) After formation of the perovskite layer, the sample was placed in a vacuum coating machine; C60 powder and BCP powder were separately placed in a quartz crucible; C60 powder was first evaporated at 0.05 Å/s to form a 5 nm thick film, and then evaporated at 0.1 Å/s to form a 30 nm thick film. Then, BCP was evaporated at 0.05 Å/s to form a 2 nm thick film, and then evaporated at 0.1 Å/s to form an 8 nm thick film, thereby forming an electron transport layer on the perovskite layer.
(5) The sample was placed into an evaporator, and a layer of Ag electrode was evaporated onto the electron transport layer to obtain a perovskite solar cell.

Conductivity and transmittance of nickel oxide film layers prepared in the above examples and comparative examples and component efficiency of perovskite solar thin film cells prepared in the above examples and comparative examples were measured, with results shown in Table 1.

**Table 1**

| Examples | Conductivity (S/m) | Transmittance (@550 nm) | Component efficiency |
|---|---|---|---|
| Example 1 | 3.22×10⁻³ | 88% | 16.2% |
| Example 2 | 1.57 | 85% | 13.6% |
| Example 3 | 1.15×10⁻² | 86% | 14.7% |
| Example 4 | 3.88 | 78% | 12.7% |
| Example 5 | 6.73×10⁻⁴ | 90% | 13.5% |
| Example 6 | 4.8 | 68% | 12.5% |
| Example 7 | 7.22×10⁻³ | 86% | 15.8% |
| Example 8 | 6.89 | 76% | 14.1% |
| Example 9 | 4.17×10⁻² | 83% | 15.5% |
| Example 10 | 4.17×10⁻³ | 76% | 13.6% |
| Comparative Example 1 | 6.73×10⁻⁵ | 62% | 5.1% |
| Comparative Example 2 | 5.27×10⁻⁶ | 86% | 10.6% |
| Comparative Example 3 | 58.9 | 60% | 8.1% |
| Comparative Example 4 | 5.01×10⁻¹⁰ | 84% | 9.6% |

A film layer fails to deliver both conductivity and transmittance due to its own reason, showing a relative inverse proportionality. As shown in Table 1, in this application, valence distribution of film layers of a same material (namely, nickel oxide (NiOx)) is improved so that the film layers deliver both better conductivity and higher transmittance, and component efficiency was improved.

As long as there is no structural conflict, various technical features mentioned in the embodiments may be combined in any manner. This application is not limited to the specific embodiments disclosed in this specification, but includes all technical solutions falling within the scope of the claims.

## Claims

1. A method for preparing a perovskite solar cell (100) comprising multiple hole transport layers, which are stacked, comprising a process of forming the multiple hole transport layers, wherein the process of forming the multiple hole transport layers comprises the following steps:
(1) sputtering a nickel oxide target material in a first atmosphere to form a first hole transport layer, wherein the first atmosphere contains argon and oxygen, and a volume ratio of the argon to the oxygen is 0:1 to 1.5: 1;
(2) performing annealing treatment on the first hole transport layer, wherein the annealing treatment is performed for 1-45 min under a temperature of 200-500°C; and
(3) sputtering the nickel oxide target material onto the first hole transport layer subjected to the annealing treatment in a second atmosphere to form a second hole transport layer, wherein the second atmosphere contains argon-containing gas and oxygen, a volume ratio of the argon-containing gas to the oxygen is 1:0 to 4:1, and the argon-containing gas contains argon, and optionally hydrogen.

2. The method according to claim 1, wherein purity of nickel oxide is approximately 95wt% or more.

3. The method according to claim 1 or claim 2, wherein magnetron sputtering is used in step (1) and/or step (3).

4. The method according to any one of claims 1 to 3, wherein a thickness of the first hole transport layer and/or the second hole transport layer is approximately 5-50 nm, particularly wherein the volume ratio of the argon to the oxygen in the first atmosphere is approximately 0:1 to 1:1.

5. The method according to any one of claims 1 to 4, wherein in step (2), the annealing treatment is performed under vacuum.

6. The method according to any one of claims 1 to 5, wherein in step (2), the annealing treatment is performed in a magnetron sputtering device under a temperature of approximately 250-450°C for approximately 5-40 min, particularly wherein the volume ratio of the argon-containing gas to the oxygen in the second atmosphere is approximately 1:0 to 5:1.

7. The method according to any one of claims 1 to 6, wherein the argon-containing gas contains argon and hydrogen, and a volume ratio of the argon to the hydrogen is approximately 90:10 to 99:1, particularly wherein the argon-containing gas contains the argon and the hydrogen, and the volume ratio of the argon to the hydrogen is approximately 95:5.

8. The method according to any one of claims 1 to 7, wherein in step (1) and/or in step (3), a sputtering power is approximately 300 W-10 kW, and an atmospheric pressure is approximately 1×10-4-100 Pa.

9. The method according to any one of claims 1 to 8, further comprising at least one of the following steps:
providing a transparent substrate (102);
forming a transparent conductive layer on the transparent substrate (102);
forming the multiple hole transport layers on the transparent conductive layer (104);
forming a perovskite layer (110) on the outermost layer of the multiple hole transport layers;
forming an electron transport layer (120) on the perovskite layer (110); and
forming a back electrode (140) on the electron transport layer (120).

10. The method according to any one of claims 1 to 8, further comprising at least one of the following steps:
providing a transparent substrate (102);
forming a transparent conductive layer (104) on the transparent substrate (102);
forming an electron transport layer (120) on the transparent conductive layer (104);
forming a perovskite layer (110) on the electron transport layer (120);
forming the multiple hole transport layers on the perovskite layer (110); and
forming a back electrode (140) on the outermost layer of the multiple hole transport layers.

## Patentansprüche

1. Verfahren zur Herstellung einer Perowskit-Solarzelle (100) mit mehreren gestapelten Lochtransportschichten, umfassend ein Verfahren zum Bilden der mehreren Lochtransportschichten, wobei das Verfahren zum Bilden der mehreren Lochtransportschichten folgende Schritte umfasst:
(1) Sputtern eines Nickeloxid-Targetmaterials in einer ersten Atmosphäre zur Bildung einer ersten Lochtransportschicht, wobei die erste Atmosphäre Argon und Sauerstoff enthält und ein Volumenverhältnis von Argon zu Sauerstoff 0:1 bis 1,5:1 beträgt;
(2) Durchführen einer Temperbehandlung an der ersten Lochtransportschicht, wobei die Temperbehandlung für 1-45 min bei einer Temperatur von 200-500 °C durchgeführt wird; und
(3) Sputtern des Nickeloxid-Targetmaterials auf die einer Temperbehandlung unterzogene erste Lochtransportschicht in einer zweiten Atmosphäre zur Bildung einer zweiten Lochtransportschicht, wobei die zweite Atmosphäre argonhaltiges Gas und Sauerstoff enthält, ein Volumenverhältnis des argonhaltigen Gases zu Sauerstoff 1:0 bis 4:1 beträgt und das argonhaltige Gas Argon und optional Wasserstoff enthält.

2. Verfahren nach Anspruch 1, wobei die Reinheit des Nickeloxids ungefähr 95 Gew.-% oder mehr beträgt.

3. Verfahren nach Anspruch 1 oder 2, wobei in Schritt (1) und/oder Schritt (3) Magnetronsputtern verwendet wird.

4. Verfahren nach einem der Ansprüche 1 bis 3, wobei eine Dicke der ersten Lochtransportschicht und/oder der zweiten Lochtransportschicht ungefähr 5-50 nm beträgt, insbesondere wobei das Volumenverhältnis von Argon zu Sauerstoff in der ersten Atmosphäre ungefähr 0:1 bis 1:1 beträgt.

5. Verfahren nach einem der Ansprüche 1 bis 4, wobei in Schritt (2) die Temperbehandlung unter Vakuum durchgeführt wird.

6. Verfahren nach einem der Ansprüche 1 bis 5, wobei in Schritt (2) die Temperbehandlung in einer Magnetronsputtervorrichtung bei einer Temperatur von ungefähr 250-450 °C für ungefähr 5-40 min durchgeführt wird, insbesondere wobei das Volumenverhältnis des argonhaltigen Gases zu Sauerstoff in der zweiten Atmosphäre ungefähr 1:0 bis 5:1 beträgt.

7. Verfahren nach einem der Ansprüche 1 bis 6, wobei das argonhaltige Gas Argon und Wasserstoff enthält und ein Volumenverhältnis von Argon zu Wasserstoff ungefähr 90:10 bis 99:1 beträgt, insbesondere wobei das argonhaltige Gas Argon und Wasserstoff enthält und das Volumenverhältnis von Argon zu Wasserstoff ungefähr 95:5 beträgt.

8. Verfahren nach einem der Ansprüche 1 bis 7, wobei in Schritt (1) und/oder Schritt (3) eine Sputterleistung ungefähr 300 W-10 kW beträgt und ein Atmosphärendruck ungefähr 1×10⁻⁴-100 Pa beträgt.

9. Verfahren nach einem der Ansprüche 1 bis 8, ferner umfassend mindestens einen der folgenden Schritte:
Bereitstellen eines transparenten Substrats (102);
Bilden einer transparenten leitfähigen Schicht auf dem transparenten Substrat (102);
Bilden der mehreren Lochtransportschichten auf der transparenten leitfähigen Schicht (104);
Bilden einer Perowskitschicht (110) auf der äußersten Schicht der mehreren Lochtransportschichten;
Bilden einer Elektronentransportschicht (120) auf der Perowskitschicht (110); und
Bilden einer Rückelektrode (140) auf der Elektronentransportschicht (120).

10. Verfahren nach einem der Ansprüche 1 bis 8, ferner umfassend mindestens einen der folgenden Schritte:
Bereitstellen eines transparenten Substrats (102);
Bilden einer transparenten leitfähigen Schicht (104) auf dem transparenten Substrat (102);
Bilden einer Elektronentransportschicht (120) auf der transparenten leitfähigen Schicht (104);
Bilden einer Perowskitschicht (110) auf der Elektronentransportschicht (120);
Bilden der mehreren Lochtransportschichten auf der Perowskitschicht (110); und
Bilden einer Rückelektrode (140) auf der äußersten Schicht der mehreren Lochtransportschichten.

## Revendications

1. Procédé de préparation d'une cellule solaire à pérovskite (100) comprenant plusieurs couches de transport de trous empilées, comprenant un procédé de formation desdites plusieurs couches de transport de trous, le procédé de formation desdites plusieurs couches de transport de trous comprenant les étapes suivantes :
(1) pulvérisation cathodique d'une cible de nickel-oxyde dans une première atmosphère afin de former une première couche de transport de trous, dans laquelle la première atmosphère contient de l'argon et de l'oxygène, et un rapport volumique de l'argon à l'oxygène est de 0:1 à 1,5:1 ;
(2) réalisation d'un traitement de recuit de la première couche de transport de trous, le traitement de recuit étant effectué pendant 1 à 45 min à une température de 200 à 500 °C ; et
(3) pulvérisation cathodique de la cible de nickel-oxyde sur la première couche de transport de trous ayant subi le traitement de recuit dans une deuxième atmosphère afin de former une deuxième couche de transport de trous, dans laquelle la deuxième atmosphère contient un gaz contenant de l'argon et de l'oxygène, un rapport volumique du gaz contenant de l'argon à l'oxygène étant de 1:0 à 4:1, et le gaz contenant de l'argon contient de l'argon et, optionnellement, de l'hydrogène.

2. Procédé selon la revendication 1, dans lequel la pureté de l'oxyde de nickel est d'environ 95 % en poids ou plus.

3. Procédé selon la revendication 1 ou 2, dans lequel la pulvérisation cathodique par magnétron est utilisée à l'étape (1) et/ou à l'étape (3).

4. Procédé selon l'une quelconque des revendications 1 à 3, dans lequel une épaisseur de la première couche de transport de trous et/ou de la deuxième couche de transport de trous est d'environ 5 à 50 nm, en particulier dans lequel le rapport volumique de l'argon à l'oxygène dans la première atmosphère est d'environ 0:1 à 1:1.

5. Procédé selon l'une quelconque des revendications 1 à 4, dans lequel, à l'étape (2), le traitement de recuit est effectué sous vide.

6. Procédé selon l'une quelconque des revendications 1 à 5, dans lequel, à l'étape (2), le traitement de recuit est effectué dans un dispositif de pulvérisation cathodique par magnétron à une température d'environ 250 à 450 °C pendant environ 5 à 40 min, en particulier dans lequel le rapport volumique du gaz contenant de l'argon à l'oxygène dans la deuxième atmosphère est d'environ 1:0 à 5:1.

7. Procédé selon l'une quelconque des revendications 1 à 6, dans lequel le gaz contenant de l'argon contient de l'argon et de l'hydrogène, et un rapport volumique de l'argon à l'hydrogène est d'environ 90:10 à 99:1, en particulier dans lequel le gaz contenant de l'argon contient l'argon et l'hydrogène, et le rapport volumique de l'argon à l'hydrogène est d'environ 95:5.

8. Procédé selon l'une quelconque des revendications 1 à 7, dans lequel, à l'étape (1) et/ou à l'étape (3), une puissance de pulvérisation est d'environ 300 W à 10 kW, et une pression atmosphérique est d'environ 1×10⁻⁴ à 100 Pa.

9. Procédé selon l'une quelconque des revendications 1 à 8, comprenant en outre au moins l'une des étapes suivantes :
fournir un substrat transparent (102) ;
former une couche conductrice transparente sur le substrat transparent (102) ;
former lesdites plusieurs couches de transport de trous sur la couche conductrice transparente (104) ;
former une couche de pérovskite (110) sur la couche la plus externe desdites plusieurs couches de transport de trous ;
former une couche de transport d'électrons (120) sur la couche de pérovskite (110) ; et
former une électrode arrière (140) sur la couche de transport d'électrons (120).

10. Procédé selon l'une quelconque des revendications 1 à 8, comprenant en outre au moins l'une des étapes suivantes :
fournir un substrat transparent (102) ;
former une couche conductrice transparente (104) sur le substrat transparent (102) ;
former une couche de transport d'électrons (120) sur la couche conductrice transparente (104) ;
former une couche de pérovskite (110) sur la couche de transport d'électrons (120) ;
former lesdites plusieurs couches de transport de trous sur la couche de pérovskite (110) ; et
former une électrode arrière (140) sur la couche la plus externe desdites plusieurs couches de transport de trous.
